Europäisches Patentamt

European Patent Office

Office européen des brevets

(11) Numéro de publication: **0 256 053 B1**

(12) **FASCICULE DE BREVET EUROPEEN**

(45) Date de publication de fascicule du brevet: **06.05.92**  (51) Int. Cl.5: **H01L 27/12**, H01L 29/78, H01L 21/84, H01L 21/86

(21) Numéro de dépôt: **87900833.2**

(22) Date de dépôt: **22.01.87**

(86) Numéro de dépôt internationale :
**PCT/FR87/00023**

(87) Numéro de publication internationale :
**WO 87/04565 (30.07.87 87/17)**

(54) **MATRICE DE TRANSISTORS EN COUCHES MINCES INTERCONNECTES ET SON PROCEDE DE FABRICATION.**

(30) Priorité: **23.01.86 FR 8600938**

(43) Date de publication de la demande:
**24.02.88 Bulletin 88/08**

(45) Mention de la délivrance du brevet:
**06.05.92 Bulletin 92/19**

(84) Etats contractants désignés:
**CH DE FR GB IT LI NL**

(56) Documents cités:
**EP-A- 0 103 523**
**EP-A- 0 112 700**
**EP-A- 0 139 585**
**DE-A- 3 502 911**
**US-A- 4 024 626**

**Patent Abstracts of Japan, vol. 9, no. 266 (E-352) (1989), 23 October 1985, & JP, A, 60111472 (MATSUSHITA DENKI SANGYO K.K.) 17 June 1985**

(73) Titulaire: **COMMISSARIAT A L'ENERGIE ATO-MIOUE Etablissement de Caractère Scientifi-que Technique et Industriel**
**31/33, rue de la Fédération**
**F-75015 Paris(FR)**

(72) Inventeur: **DIEM, Bernard**
**63, rue des Aiguinards**
**F-38240 Meylan(FR)**

(74) Mandataire: **Mongrédien, André et al**
**c/o BREVATOME 25, rue de Ponthieu**
**F-75008 Paris(FR)**

Rank Xerox (UK) Business Services
(3.08/2.19/2.0)

Patent Abstracts of Japan, vol. 9, no. 255 (E-349) (1978), 12 October 1985, & JP, A, 60105275 (SEIKO DENSHI KOGYO K.K) 10 June 1985

Patent Abstracts of Japan, vol. 9, no. 204 (E-337) (1927), 21 August 1985, & JP, A, 6066864 (SEIKO DENSHI KOGYO K.K) 17 April 1985

## Description

La présente invention a pour objet une matrice de transistors en couches minces interconnectés utilisables notamment pour la commande de l'affichage d'écrans plats à cristaux liquides et son procédé de fabrication par les techniques de photogravure utilisant au maximum trois niveaux de masquage.

D'une façon générale, elle permet la fabrication des composants semi-conducteurs en couches minces pouvant servir au multiplexage de tels composants disposés sous forme matricielle, ainsi qu'à la réalisation de dispositifs à transfert de charge (DTC en abrégé).

Plus particulièrement, elle permet la fabrication de matrices de transistors en couches minces (TCM en abrégé) pouvant servir en opto-électronique à la réalisation de la mémoire électronique des écrans plats à cristaux liquides. Cette mémoire électronique qui stocke le signal vidéo pendant toute la durée de l'image est réalisée, sous forme de matrice active de points mémoire ou pixels constitués chacun d'un TCM, dont le drain est relié à une électrode point formant condensateur avec une plaque conductrice couvrant le cristal liquide sur toute l'étendue de la matrice. Chaque pixel de l'image est ainsi défini par l'état électrique du condensateur élémentaire ainsi constitué qui, selon le champ électrique qu'il engendre, rend le point correspondant du cristal liquide plus ou moins transparent.

On connaît déjà bon nombre de procédés de fabrication de TCM pour lesquels deux techniques sont essentiellement utilisées : la technique "grille dessus" où la grille est réalisée en dernier sur la structure semi conductrice et la technique "grille dessous" où la grille est réalisée en premier sur le substrat.

La première technique décrite par F.A HUNTLEY et publiée dans "IBM Technical Disclosure Bulletin" 21, n° 9, Février 1979, comprend deux niveaux de masquage : le premier pour la photogravure des contacts source-drain et le deuxième pour la photogravure des lignes conductrices et la photogravure de la grille du transistor. Pour chaque photogravure, on place un photomasque au-dessus de la structure empilée que l'on a précédemment recouverte d'une couche de résine. On irradie à travers ce photomasque pour polymériser sélectivement la couche de résine. Une phase de développement permet d'enlever les zones irradiées de cette couche. La couche de résine protégée par le photomasque subsiste après cette phase de développement et sert de masque à la gravure des couches de la structure empilée. Malheureusement, cette technique "grille dessus" n'offre pas les meilleurs caractéristiques pour la fabrication de composants servant à la réalisation de matrices actives pour les écrans plats à cristaux liquides.

La seconde technique dite "grille dessous" demande dans sa mise en oeuvre au moins quatre niveaux de masquage. Le premier pour la photogravure de la grille du TCM, le second pour la photogravure de la couche semi-conductrice, le troisième pour la photogravure des contacts ohmiques de drains et de source et enfin le quatrième pour la photogravure des interconnections du drain et de la source du TCM à leurs conducteurs respectifs. Elle est décrite notamment dans la publication[+]

Une telle technique présente l'inconvénient de nécessiter de nombreux niveaux de masquage, ce qui rend la fabrication délicate, longue et coûteuse.

Dans l'art antérieur d'une façon générale, si l'on veut appliquer les techniques connues qui viennent d'être rappelées pour réaliser des matrices de transistors, en couches minces, on fait appel au procédé de photogravure en fabriquant d'abord les transistors situés aux différents points de la matrice et l'on grave ensuite séparément - d'où un niveau de masquage élevé - les différentes connections électriques reliant ces transistors entre eux, connections qui sont généralement réalisées en aluminium déposé sous vide. C'est dire que la fabrication d'une telle matrice est une opération relativement complexe, délicate et par là même coûteuse.

La présente invention a justement pour objet une matrice de transistors en couches minces et son procédé de fabrication qui permet de remédier en grande partie aux inconvénients de l'art antérieur en utilisant la technique "grille dessous" et en gravant en une seule opération de masquage et en un même matériau tous les conducteurs de source de drains et des éléctrodes point de la structure. Elles permettent ainsi de réduire le nombre de niveaux de masquage de quatre à deux (ou trois pour une variante du procédé). Grâce à l'invention, de meilleurs rendements de fabrication sont obtenus, les cadences de production des circuits sont augmentées et les coûts de fabrication diminués.

L'invention a pour objet une matrice de transistors en couches minces interconnectés notamment pour la commande de l'affichage d'écrans plats à cristaux liquides dont l'état de transmission optique de chaque point de l'écran ou pixel associé à l'un des transistors de la matrice est commandé par l'état électrique de l'électrode point du pixel reliée à l'électrode drain du transistor associé, compor-

[+]Proceedings of Japan Display, 1983, p. 356, "Amorphous Si TFT Active Matrix LCTV" et dans EP-A-0 112 700.

tant sur un substrat lesdits transistors de la matrice reliés par des conducteurs de grille, de source et de drain disposés selon les deux directions perpendiculaires de la matrice, caractérisé en ce que :

- les conducteurs de grilles comportent une ligne conductrice placée sur le substrat et noyée dans une couche isolante revêtant toute la surface de ce substrat et une ligne d'un premier matériau semi-conducteur surmontant la ligne conductrice de grille ;
- les conducteurs de source et de drain, ainsi que les électrodes points sont réalisés en un même matériau conducteur et transparent ;
- la matrice est du type à conducteurs non croisés, en ce sens que les lignes de la matrice sont occupées chaque fois par un conducteur de grille et un conducteur de source juxtaposés, les transistors étant formés par superposition à angle droit d'une branche dérivée du conducteur de grille (G1,G2,G3,G4...) située selon les colonnes de la matrice, d'une branche dérivée du conducteur de source (S1,S2,S3,S4) située selon les colonnes de la matrice entre les conducteurs de source et de grille appartenant à deux lignes adjacentes de la matrice, et du conducteur de drain (D1,D2,D3,D4) parallèle à la direction des lignes de la matrice.

L'invention a également pour objet un procédé de fabrication d'une matrice de transistors en couches minces interconnectés, qui se caractérise essentiellement par les étapes suivantes :

- dépôt sur un substrat isolant d'une première couche conductrice d'un premier matériau métallique et opaque à la lumière ;
- première photogravure à l'aide d'un premier masque, appliquée par dessus à cette première couche pour constituer les lignes de conducteurs de grilles des futurs transistors de la matrice ;
- dépôt d'une première couche d'isolant sur le substrat et la première couche conductrice ;
- dépôt d'une première couche de silicium amorphe hydrogéné sur la première couche d'isolant ;
- dépôt d'une seconde couche de silicium amorphe hydrogéné de type $n^+$ sur la première couche de silicium ;
- dépôt d'une couche de résine photosensible positive sur la seconde couche de silicium;
- irradiation de la couche de résine par en dessous à travers le substrat, le conducteur de grille servant de masque à l'irradiation;
- développement de la couche de résine, conduisant à l'élimination des zones irradiées de ladite couche de résine;

- gravure des première et seconde couches de silicium jusqu'à mise à nu de la première couche d'isolant, la résine restante servant de masque à ladite gravure,
- élimination de la résine restante ;
- dépôt d'une deuxième couche d'un second matériau conducteur transparent constitutif des futurs conducteurs de source, de drain et des électrodes points,
- seconde photogravure à l'aide d'un second masque, appliquée par dessus à l'ensemble seconde couche conductrice - seconde couche de silicium pour délimiter les conducteurs de source, de drain, ainsi que les électrodes points de la matrice.

Selon ce procédé, une matrice complète de transistors à couches minces interconnectés est obtenue à l'aide de deux niveaux de masquage seulement, puisque les lignes de grilles sont utilisées comme dans la technique "grille dessous" comme masque au cours de l'une des irradiations et que d'autre part, les conducteurs et électrodes de source, de drain, ainsi que les électrodes points de chaque pixel, sont réalisés en un même matériau simultanément. On voit ainsi que l'originalité essentielle du procédé objet de l'invention, réside dans le fait que l'on grave sur un substrat les différents conducteurs de grilles de source et de drain et que les transistors de la matrice résultent, en quelque sorte comme sous produit , de leur superposition aux points de croisement de ces électrodes. Tout l'intérêt du procédé objet de l'invention, découle de ce fait que l'on grave d'abord les conducteurs et que les transistors résultent de ces gravures, alors que dans l'art antérieur c'est l'inverse puisque l'on commençait par graver les transistors au sommet de la matrice et qu'il fallait les relier ensuite électriquement par des connections conductrices qui étaient réalisées après et nécessitaient par conséquent des opérations de photogravure complémentaires.

Selon une variante du procédé de fabrication d'une matrice de transistors en couches minces interconnectés, objet de l'invention, on équipe chaque transistor d'un écran opaque, le protégeant de la lumière pour améliorer son fonctionnement. Cette variante se caractérise par le fait qu'elle comprend, après la seconde photogravure appliquée à l'ensemble seconde couche conductrice - seconde couche de silicium et l'élimination de la résine restante les étapes suivantes :

- dépôt d'une seconde couche d'isolant sur la seconde couche conductrice ;
- dépôt d'une couche d'un troisième matériau opaque à la lumière sur la seconde couche d'isolant ;

- troisième photogravure à l'aide d'un troisième masque, appliquée par dessus à l'ensemble troisième couche opaque - seconde couche isolante et première couche de silicium pour délimiter un écran à la lumière, protégeant chaque transistor.

Selon l'invention, le matériau conducteur et transparent utilisé pour la réalisation des conducteurs de source de drain et des électrodes points des pixels, peut être de l'oxyde d'étain, de l'oxyde d'indium ou l'oxyde mixte étain/indium connu en terminologie anglo-saxonne sous le sigle ITO.

Selon l'invention également, le troisième matériau opaque à la lumière utilisé dans la variante précédente peut être soit une résine, soit un polymère photosensible que l'on colore. Dans ce dernier mode de mise en oeuvre, la seconde couche d'isolant que l'on dépose sur la seconde couche conductrice peut, le cas échéant, être supprimée.

Les deux niveaux de masquage qui restent de toute façon nécessaires dans la mise en oeuvre du procédé, objet de l'invention, correspondent pour la première photogravure aux conducteurs de grilles des transistors et pour la seconde photogravure, aux conducteurs de drains, de sources, et des électrodes points des pixels.

D'autres caractéristiques et avantages de l'invention ressortiront mieux de la description qui va suivre, donnée à titre illustratif mais non limitatif, en référence aux figures annexées 1 à 10, qui illustrent les matrices (fig. 1 et 2) et les différentes étapes du procédé de fabrication selon l'invention (fig. 3 à 10). Sur ces figures on a représenté :

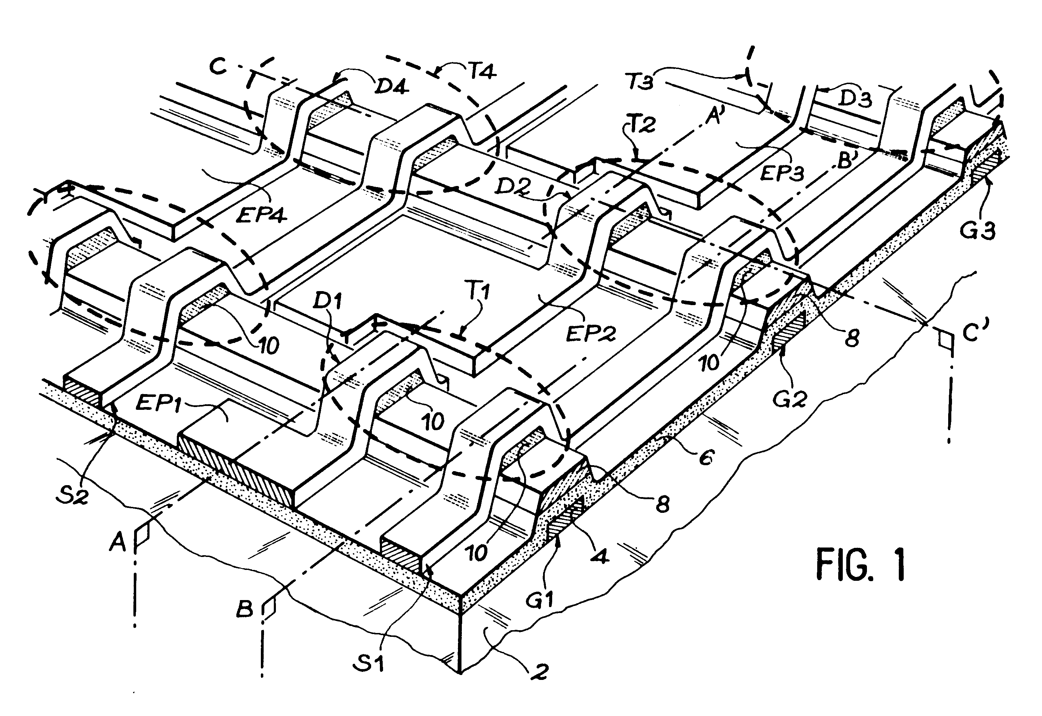

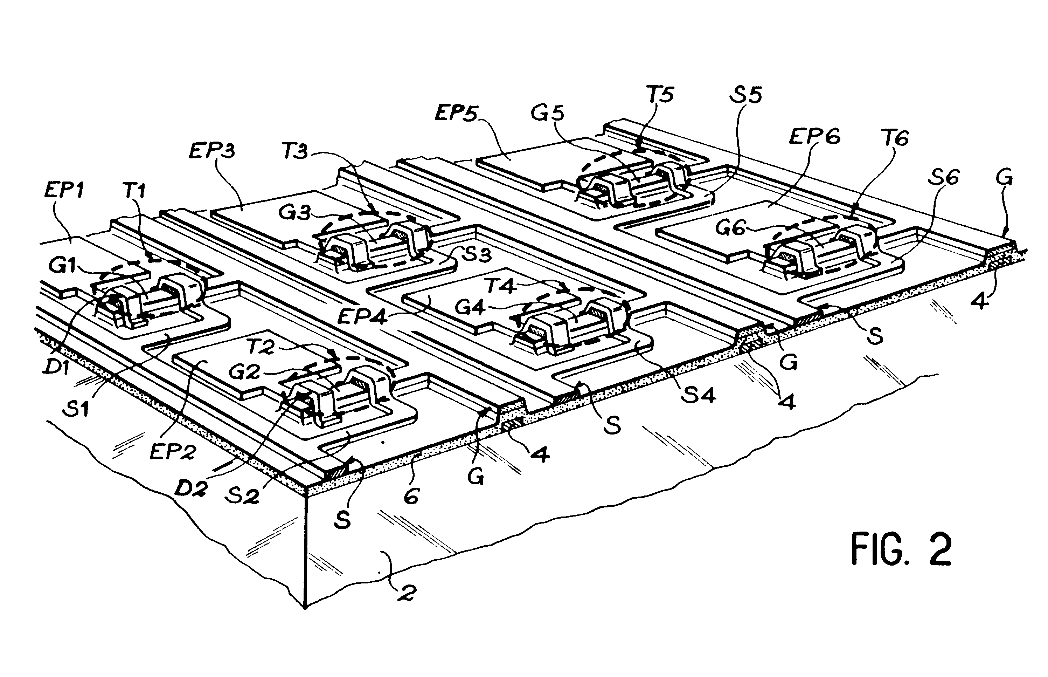

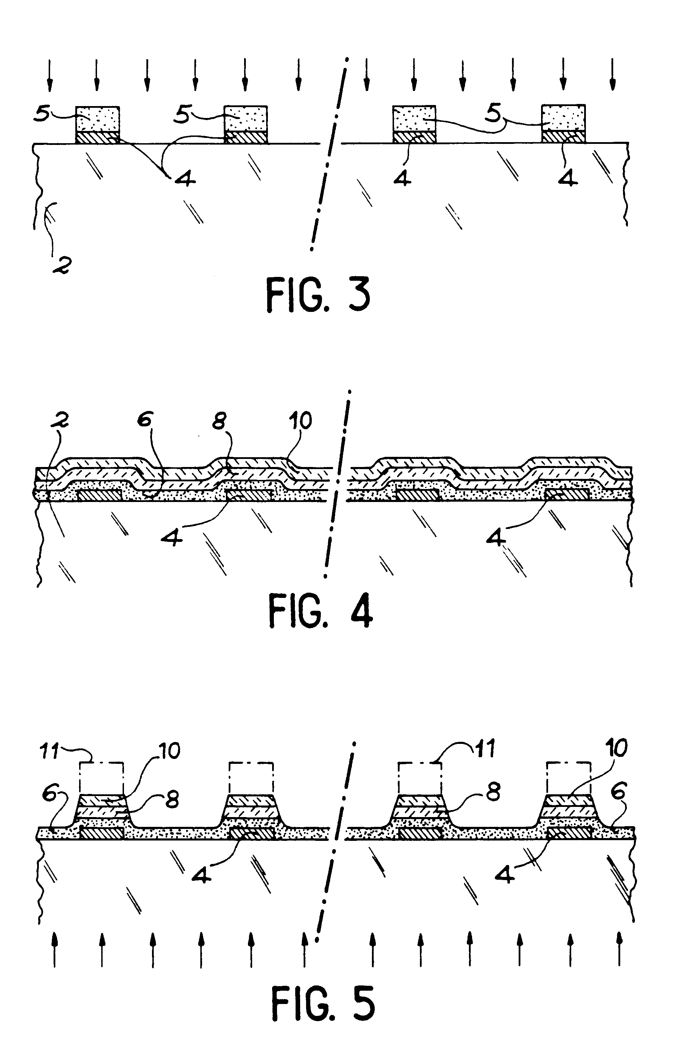

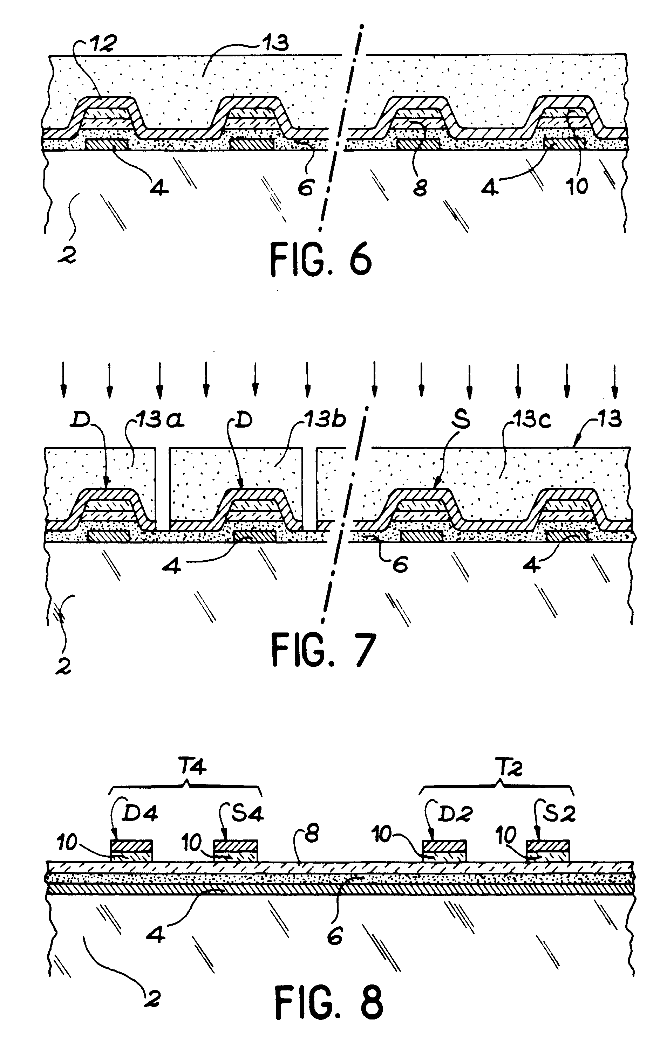

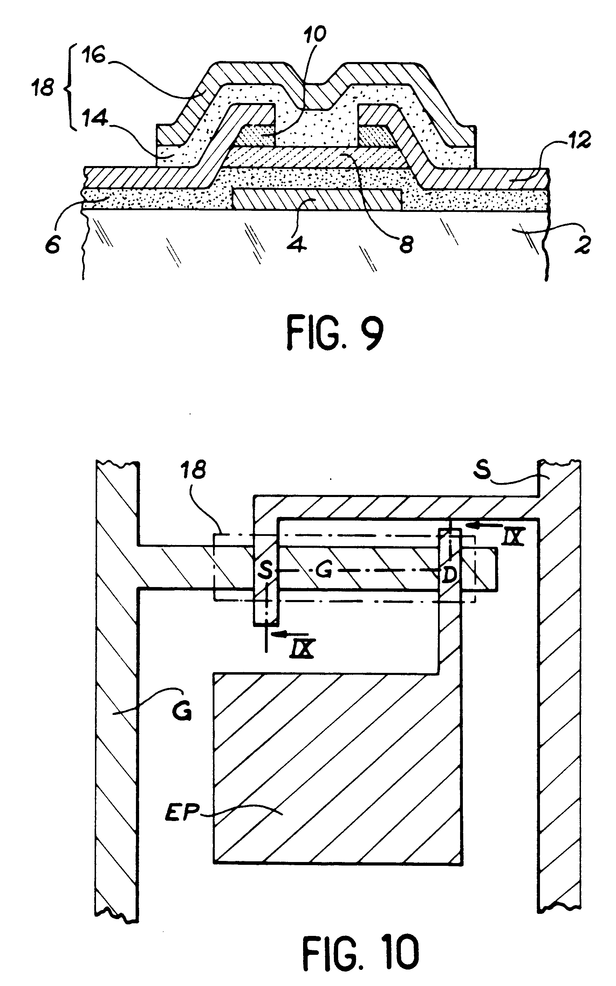

- en figure 1, une vue de dessus en perspective cavalière d'une matrice de transistors en couches en minces, réalisée dans la structure à conducteurs croisés ;
- en figure 2, une vue de dessus en perspective cavalière d'une matrice selon l'invention, réalisée dans la structure à conducteurs non croisés ;
- en figure 3, l'étape comprenant la première photogravure appliquée à la première couche conductrice pour constituer les conducteurs de grille des TCM de la matrice ;
- en figure 4, l'étape comprenant le dépôt successif de la première couche d'isolant, de la première couche de silicium et de la seconde couche de silicium ;
- en figure 5, l'étape comprenant la gravure des première et seconde couches de silicium jusqu'à la mise à nu de la première couche d'isolant;
- en figures 6 et 7, l'étape comprenant la seconde photogravure appliquée à l'ensemble seconde couche conductrice - seconde couche de silicium pour délimiter les conducteurs de source et de drain des TCM de la matrice ;
- en figure 8, une coupe selon un conducteur de grille de la matrice de la fig. 1;
- en figure 9, un TCM d'une matrice obtenue selon la variante du procédé selon l'invention et représenté selon la coupe IX-IX de la fig. 10;
- en figure 10, une vue de dessus du transistor de la fig. 9 dans une structure matricielle à conducteurs non croisés réalisée selon la variante du procédé selon l'invention.

Dans les figs. 3 à 7 précédentes, la partie gauche du dessin représente une coupe verticale selon AA'de la structure matricielle de la fig. 1 et la partie droite de ce même dessin représente une coupe verticale selon BB' de la même structure matricielle de la fig. 1.

La fig. 8 est une coupe verticale selon CC' de la structure matricielle de la fig. 1.

Sur la fig. 1 on a représenté, vue de dessus et en perspective cavalière, une matrice de transistors en couches minces interconnectés, dans la réalisation dite à conducteurs croisés. Sur cette figure, qui montre une portion d'une telle matrice limitée par deux plans verticaux à angle droit, on distingue un substrat 2 sur lequel repose une couche 6 isolante en silice $SiO_2$ et où l'on voit un certain nombre de transistors T1, T2, T3 et T4 situés aux sommets des mailles du réseau de la matrice. Dans le mode de réalisation de la fig. 1, les lignes de la matrice sont occupées par des conducteurs de grilles tels que G1, G2 et G3 disposés selon la direction des lignes de la matrice et comportant une électrode de grille proprement dite 4 en nickel-chrome noyée dans la couche d'isolant 6 et surmontée de deux couches semi conductrices 8 et 10.

Selon la direction des colonnes de la même matrice, qui font évidemment un angle droit avec les lignes précédentes, sont disposés des conducteurs de sources S1 et S2 et des conducteurs de drains D1, D2 et D3 Les lignes de grilles G1, G2 s'étendent de façon continue dans la direction des lignes de la matrice, mais la seconde couche 10 de semi-conducteurs n'est constituée que de pavés localisés entre chaque conducteur de grille et les conducteurs de source et de drains qui les recouvrent. En d'autres termes, cette deuxième couche 10, semi-conductrice, est donc discontinue.

Ainsi qu'il est d'usage, dans les matrices de transistors en couches minces servant à commander l'état d'un afficheur à cristaux liquides, cet affichage est réalisé à l'aide d'un certain nombre d'électrodes points EP1, EP2, EP3, EP4, qui constituent l'électrode point de chaque pixel de l'écran et sont reliés chacune à un transistor associé, en l'occurence le transistor T1 pour l'électrode EP1, le transistor T2 pour l'électrode EP2, le transistor T4 pour l'électrode EP4 etc... C'est, de façon connue, cette électrode point de chaque pixel, qui en liaison avec une plaque conductrice parallèle à la matrice et entre lesquelles se trouve le cristal liquide , permet par application d'un champ électrique local, de rendre ce cristal liquide en chaque point plus ou moins opaque ou transparent.

La fig, 2, représente une portion de matrice de transistors à couches minces interconnectés selon l'invention dans la réalisation dite à conducteurs non croisés; Dans ce mode de mise en oeuvre, les différentes lignes de la matrice sont constituées par des conducteurs de grilles G et de source S, conjoints au niveau de chaque ligne. Selon la direction perpendiculaire des colonnes de la matrice, se trouvent réparties des branches dérivées des conducteurs de grilles telles que G1, G2, G3, G4, G5 et G6, et des branches dérivées des conducteurs de source S1, S2, S3, S4, S5 et S6. Comme dans la réalisation précédente, les électrodes points des pixels de la matrice d'affichage sont représentées par les électrodes EP1, EP2, EP3, EP4, EP5 et EP6, reliées par des conducteurs courts disposés selon la direction des lignes de la matrice et reliés aux drains des différents transistors correspondants T1, T2, T3, T4, T5 et T6.

Dans la réalisation de la fig.2, les différents conducteurs de grilles et de sources ont la même constitution que dans la réalisation de la fig. 1, et dans un cas comme dans l'autre, les électrodes de chaque transistor sont constituées par le recouvrement croisé, selon les deux directions de la matrice, des conducteurs de grilles par les conducteurs de sources et de drains. La structure matricielle de la fig. 2, à conducteurs non croisés, telle qu'elle est représentée sur la fig. 2, offre un avantage important qui est la suppression des transistors parasites.

On va décrire maintenant, en se référant aux figs. 3 et suivantes, les différentes étapes de réalisation sur le substrat 2 d'une matrice de transistors en couches minces selon l'une des réalisations des figs. 1 et 2.

Comme représenté sur la fig. 1, la première étape du procédé consiste à recouvrir le substrat 2 d'une première couche métallique opaque 4 réalisée de préférence en nickel-chrome. Cette première couche conductrice 4 présentant par exemple une épaisseur de l'ordre de 50 nm est obtenue par dépôt, par exemple par évaporation sous vide ou par pulvérisation. On dépose ensuite sur la première couche conductrice une couche de résine photosensible positive sensible à la lumière ayant une longueur d'onde de l'ordre de 500 nm. Cette couche de résine peut être notamment déposée par centrifugation. Comme résine, on peut utiliser des résines à base de phénolformaldéhyde comme celles vendues par la Société HUNT sous la référence HPR 204.

La couche de résine est irradiée par dessus à travers un premier masque (premier niveau de masquage)(non représenté sur la fig. 3) placé au-dessus de la structure empilée et contenant les informations sur la forme des conducteurs de grille 4. (Les flèches portées sur la fig. 1, indiquent le sens de l'irradiation).

Le développement de la couche de résine permet de ne garder de cette couche que les zones 5 protégées par ce premier masque.

On grave ensuite la première couche conductrice 4 par voie humide, la résine restante 5 servant de masque à ladite gravure étant éliminée une fois l'opération de gravure terminée. Cette première photogravure appliquée à cette première couche conductrice permet de constituer les grilles 4 des futurs transistors de la matrice.

On rappellera, pour la compréhension de l'exposé, que les deux grilles 4 de la moitié gauche des fig. 3 à 7 appartiennent respectivement aux transistors T1 et T2 dans la coupe AA' de la fig. 1 et que les deux grilles 4 de la moitié droite des fig. 3 à 7 appartiennent respectivement aux mêmes transistors T1 et T2 dans la coupe BB' de la fig. 1

Comme représenté sur la fig. 4, on dépose ensuite sur le substrat 2 et les grilles 4 des transistors, une première couche d'isolant 6, réalisée de préférence en oxyde de silicium. Cette première couche d'isolant présentant par exemple une épaisseur de 100 nm peut être obtenue à une température de dépôt de l'ordre de 300°C par la technique de dépôt chimique en phase vapeur, à basse pression ou non, ou bien par la technique de décharge luminescente, dans un appareil à radiofréquence, en utilisant un mélange gazeux de $SiH_4$ et de $O_2$.

On dépose ensuite, et de préférence dans le même vide, sur la première couche d'isolant 6, une première couche de silicium amorphe hydrogéné 8 présentant avantageusement une épaisseur variant de 50 nm à 150 nm. De préférence, l'épaisseur de la couche de silicium est voisine de 100 nm et la température de dépôt de l'ordre de 300°C. Cette première couche de silicium peut être obtenue par la technique de décharge luminescente en utilisant le gaz $SiH_4$.

Sur l'ensemble de la structure, on dépose ensuite et de préférence dans le même vide, une seconde couche de silicium amorphe 10 de type $n^+$, hydrogéné ou non, présentant une épaisseur variant de 20 à 50 nm. Cette seconde couche de silicium 10, déposée par la même technique et dans les mêmes conditions de dépôt que la première couche de silicium, permet la réalisation ultérieure des contacts ohmiques pour les sources et les drains des TCM de la matrice.

Comme représenté sur la figure 5, l'étape suivante du procédé consiste à déposer, par exemple par centrifugation, sur la seconde couche de silicium amorphe hydrogéné 10 de type n$^+$, une couche de résine photosensible positive, de mêmes caractéristiques que celles de la résine précédemment utilisée pour la gravure des grilles des transistors de la matrice.

La couche de résine photosensible est ensuite irradiée par en dessous à travers le substrat 2, la grille 4 servant de masque à l'irradiation (sur la fig. 5, les flèches indiquent le sens de l'irradiation).

Le développement de la couche de résine permet de ne garder de cette couche que les zones 11, situées au droit des grilles 4 des transistors, les zones irradiées étant éliminées.

On grave ensuite successivement la seconde couche 10 et la première couche 8 de silicium jusqu'à mise à nu de la première couche d'isolant 6, la résine réstante 11 servant de masque à ladite gravure (fig. 5).

A cet effet, et de façon avantageuse, les première et seconde couches de silicium (8 et 10) peuvent être attaquées chimiquement par des gravures partielles et successives, comme celles décrites dans le brevet français n° 8516922 du 15 novembre 1985 et qui permettent d'obtenir sur les flancs des première et seconde couches de silicium un certain nombre de marches.

Comme représenté sur la figure 6, on recouvre, après l'élimination de la résine restante 11, l'ensemble de la structure d'une seconde couche 12 conductrice, présentant par exemple une épaisseur de 150 nm, et obtenue par dépôt, par exemple par évaporation sous vide ou par pulvérisation. Les marches éventuelles réalisées précédemment sur les flancs des première et seconde couches de silicium permettant d'améliorer la couverture par le dépôt de cette seconde couche conductrice 12 qui y trouve ainsi un accrochage renforcé.

Dans le cas d'une utilisation des TCM fabriqués par le procédé selon l'invention dans des matrices actives pour les écrans plats à cristaux liquides, la seconde couche conductrice 12 est réalisée de préférence en oxyde d'étain et/ou d'indium (ITO en terminologie anglo-saxonne). Ce matériau, transparent et conducteur, fournira la substance des futurs conducteurs de source et de drain, ainsi que des électrodes points des pixels.

On parachève les étapes du procédé selon l'invention par une seconde photogravure appliquée à l'aide d'un second masque (second niveau), à l'ensemble seconde couche conductrice

12 - seconde couche de silicium 10 pour délimiter les conducteurs de source et de drain des TCM de la matrice.

Cette seconde photogravure consiste tout d'abord à déposer sur la seconde couche conductrice 12 une couche de résine photosensible positive 13 de mêmes caractéristiques que celles des résines précédemment utilisées. La couche de résine 13 est irradiée à travers un second niveau de masquage (non représenté sur la figure 7) placé au-dessus de la structure empilée, (Les flèches portées sur la fig. 7 indiquent le sens de l'irradiation). Le développement de la couche de résine permet de ne garder de cette couche que les zones 13a , 13b, 13c protégées par le masque. On grave ensuite la seconde couche conductrice 12 et la seconde couche de silicium 10 jusqu'à la mise à nu de la première couche de silicium 8. La résine restante 13 servant de masque à ladite gravure est éliminée une fois l'opération de gravure terminée. La position du deuxième masque n'est pas critique ; il peut être placé dans le sens horizontal avec une certaine latitude compatible néanmoins avec la réalisation d'un positionnement correct des trois électrodes les unes au-dessus des autres. Cette faculté constitue une simplification pour le procédé objet de l'invention.

Comme représentée sur la fig. 1, la grille G proprement dite de chaque TCM est constituée par la partie du conducteur de grille qui est située entre la branche dérivée de l'électrode point et le conducteur de source. Le drain D et la source S de chaque TCM sont respectivement constitués par le recouvrement croisé du conducteur de grille par les conducteurs de source et de drain.

La première photogravure du procédé selon l'invention appliquée à la couche de métal 4 des TCM délimite les grilles des TCM et la largeur du conducteur de grille. La deuxième photogravure du procédé selon l'invention appliquée à l'ensemble seconde couche conductrice 12 - seconde couche de silicium 10 délimite les sources S, les drains D des TCM et les électrodes points et détermine la longueur des canaux des TCM qui relient les drains aux sources de ceux-ci.

Comme représenté sur la figure 2, les grilles 4 des TCM sont constituées par la partie des conducteurs G qui est située entre la branche dérivée de l'électrode point et la branche dérivée du conducteur de source. Les drains D et les sources S sont respectivement constitués par le recouvrement croisé du conducteur de grille par les conducteurs de source et de drain.

La première et la seconde photogravures du procédé selon l'invention déterminent respectivement d'une part les grilles des TCM et la largeur des conducteurs de grille et d'autre part les sources S, les drains D des TCM et la longueur des canaux des TCM qui relient les drains aux sources de ceux-ci.

La fig. 8 montre, en coupe verticale selon CC' de la fig. 1, l'état définitif d'un conducteur de grille de la matrice. On y voit, à gauche, le drain $D_4$ et la source $S_4$ du transistor T4 de la fig. 1 et, à droite, le drain D2 et la source S2 du transistor T2. On remarque également sur cette figure les pavés de la seconde couche semi-conductrice 10 placés sous les électrodes de drain et de source.

Une variante du procédé de fabrication, selon l'invention, permet de supprimer le transistor parasite situé de l'autre côté du conducteur de source, dans le cas de la structure à conducteurs croisés de la fig. 1, et de réaliser un écran opaque à la lumière.

Comme représenté sur la figure 9, cette variante du procédé consiste à déposer une seconde couche d'isolant 14 après la photogravure de la seconde couche conductrice 12 et de la sec ode couche de silicium 10 et après l'élimination de la résine restante 13 utilisée pour cette photogravure. La seconde couche d'isolant 14 est réalisée de préférence en oxyde de silicium et présente par exemple une épaisseur de l'ordre de 200 à 300 nm. Elle est obtenue par la même technique que celle utilisée précédemment par le dépôt de la première couche d'isolant.

On dépose sur l'ensemble de la structure une troisième couche 16 opaque à la lumière pouvant être constituée par la résine utilisée pour le masquage et que l'on colore en noir. S'il s'agit d'un polymère photosensible que l'on colore, il est possible de supprimer la seconde couche d'isolant.

Enfin, on parachève la variante du procédé selon l'invention par une troisième photogravure appliquée à l'ensemble troisième couche opaque 16 - seconde couche d'isolant 14 et première couche de silicium 8 pour délimiter un écran à la lumière 18 constitué des couches 16 et 14, qui recouvre chaque transistor et que l'on voit en plan et en pointillé sur la fig. 10.

Comme représenté sur la fig. 10, la forme de l'écran 18, semblable à celle du troisième masque de la troisième photogravure (troisième niveau de masquage) est représentée en pointillés. Cet écran 18 supprime le transistor parasite situé de l'autre côté de la ligne de grille G, dans le cas d'une structure matricielle à conducteurs croisés.

Dans le cas d'une structure à conducteurs non croisés, figure 10, le transistor parasite n'a plus d'influence sur le condensateur constitué par l'électrode point EP, celui-ci étant écranté par le conducteur de source S qui est à basse impédance.

Le procédé selon l'invention permet ainsi de réaliser en deux plans de masquage ou photogravures une matrice de transistors selon les structures de la figur 2, L'adjonction d'un troisième plan de masquage ou photogravure complémentaire permet, de surcroît, de graver au-dessus de chaque transistor de la matrice, un cache opaque protecteur, l'isolant de la lumière.

## Revendications

1. Matrice de transistors en couches minces interconnectés notamment pour la commande de l'affichage d'écrans plats à cristaux liquides dont l'état de transmission optique de chaque point de l'écran ou pixel associé à l'un des transistors de la matrice est commandé par l'état électrique de l'électrode point (EP) du pixel reliée à l'électrode drain du transistor associé, comportant sur un substrat lesdits transistors de la matrice reliés par des conducteurs de grille (G), de source (S) et de drain (D) disposés selon les deux directions perpendiculaires de la matrice, caractérisé en ce que :
   - les conducteurs de grilles (G) comportent une ligne conductrice (4) placée sur le substrat et noyée dans une couche isolante (6) revêtant toute la surface de ce substrat et une ligne (8) d'un premier matériau semi-conducteur surmontant la ligne conductrice de grille ;
   - les conducteurs de source (S) et de drain (D), ainsi que les électrodes points (EP) sont réalisés en un matériau conducteur et transparent ;
   - la matrice est du type à conducteurs non croisés, en ce sens que les lignes de la matrice sont occupées chaque fois par un conducteur de grille et un conducteur de source juxtaposés, les transistors étant formés par superposition à angle droit d'une branche dérivée du conducteur de grille (G1,G2,G3,G4...) située selon les colonnes de la matrice, d'une branche dérivée du conducteur de source (S1,S2,S3,S4) située selon les colonnes de la matrice entre les conducteurs de source et de grille appartenant à deux lignes adjacentes de la matrice, et du conducteur de drain (D1,D2,D3,D4) parallèle à la direction des lignes de la matrice.

2. Procédé de fabrication d'une matrice de transistors en couches minces interconnectés, notamment pour la commande de l'affichage d'écran plats à cristaux liquides dont l'état de transmission optique de chaque point de l'écran correspondant à l'un des transistors de la matrice est commandé par l'état électrique de l'électrode point du pixel reliée à l'électrode drain du transistor associé, comportant sur un substrat lesdits transistors de la matrice reliés par des conducteurs de grille, de source et de drain disposés selon les deux directions perpendiculaires de la matrice, caractérisé en ce qu'il comprend les étapes suivantes :

- dépôt sur un substrat isolant (2) d'une première couche conductrice d'un premier matériau métallique et opaque à la lumière (4),
- première photogravure à l'aide d'un premier masque, appliquée par dessus à cette première couche pour constituer selon les lignes de la matrice les lignes de conducteurs de grilles des futurs transistors de la matrice,
- dépôt d'une première couche d'isolant (6) sur le substrat (2) et la première couche conductrice,
- dépôt d'une première couche de silicium amorphe hydrogéné (8) sur la première couche d'isolant (6),
- dépôt d'une seconde couche de silicium amorphe hydrogéné de type n$^+$ (10) sur la première couche de silicium (8),
- dépôt d'une couche de résine photosensible (11) positive sur la seconde couche de silicium (10),
- irradiation de la couche de résine par en dessous à travers le substrat, le conducteur de grille servant de masque à l'irradiation,
- développement de la couche de résine, conduisant à l'élimination des zones irradiées de ladite couche de résine,
- gravure des première et seconde couches de silicium (8) et (10) jusqu'à mise à nu de la première couche d'isolant (6), la résine restante (11) servant de masque à ladite gravure,
- élimination de la résine restante (11),
- dépôt d'une deuxième couche d'un second matériau conducteur transparent (12) constitutif des futurs conducteurs de source, de drain et des électrodes points, puis d'une nouvelle couche de résine (13),
- seconde photogravure à l'aide d'un second masque, appliquée par dessus à l'ensemble résine (13), seconde couche conductrice (12) - seconde couche de silicium (10) pour délimiter les conducteurs de source, de drain, ainsi que les électrodes points de la matrice.

3. Procédé selon la revendication 2 , caractérisé en ce qu'il comprend après la seconde photogravure appliquée à l'ensemble seconde couche conductrice (12) - seconde couche de silicium (10) et l'élimination de la résine restante (13) les étapes suivantes :
- dépôt d'une seconde couche d'isolant (14) sur la seconde couche conductrice (12),
- dépôt d'une couche d'un troisième matériau opaque à la lumière -16) sur la seconde couche d'isolant (14),
- troisième photogravure à l'aide d'un troisième masque, appliquée par dessus à l'ensemble troisième couche opaque (16) - seconde couche isolante (14) et première couche de silicium (8) pour délimiter un écran (18) à la lumière, protégeant chaque transistor.

4. Procédé selon l'une quelconque des revendications 2 et 3, caractérisé en ce que le second matériau conducteur et transparent (12) constituant les conducteurs de source, de drain et les pixels est de l'oxyde d'étain et/ou d'indium.

5. Procédé selon l'une quelconque des revendications 2 et 4 , caractérisé en ce que le troisième matériau opaque à la lumière (16) est un polymère photosensible que l'on colore.

**Claims**

1. Matrix of interconnected thin film transistors particularly for the control of the display of flat-faced liquid crystal screens, whereof the optical transmission state of each point of the screen or pixel associated with one of the transistors of the matrix is controlled by the electrical state of the point electrode (EP) of the pixel connected to the drain electrode of the associated transistor, having on a substrate the said transistors of the matrix connected by the gate (G), source (S) and drain (D) conductors arranged in accordance with two perpendicular directions of the matrix, characterized in that the gate conductors (G) have a conductive line (4) placed on the substrate and embedded in an insulating film (6) coating the entire surface of said substrate and a line (8) of a first semiconductor material surmounting the gate conducting line; source (S) and drain (D) conductors, as well as point electrodes (EP) made from the same conductive, transparent material; the matrix being of the non-crossed conductor type, the rows of the matrix being occupied on each occasion by a gate conductor and a source conductor in juxtaposed manner, the transistors being formed by superimposing a branch derived from the gate conductor (G1, G2, G3, G4, etc.) positioned in accordance with the columns of the matrix, a branch derived from the source conductor (S1, S2, S3, S4) positioned along the columns of the matrix between the source and gate conductors belonging to two adjacent rows of the matrix and the drain conductor (D1, D2, D3, D4) parallel to the direction of the matrix rows.

2. Process for producing a matrix of interconnected thin film transistors, particularly for the control of the display of flat-faced liquid crystal screens, whereof the optical transmission state of each point of the screen corresponding to one of the transistors of the matrix is controlled by the electrical state of the point electrode of the pixel connected to the drain electrode of the associated transistor, having on a substrate said matrix transistors connected by gate, source and drain conductors disposed in the two perpendicular directions of the matrix, characterized in that it comprises the following stages:
deposition on an insulating substrate (2) of a first conductive film of a first light-opaque, metallic material (4);
first photogravure with the aid of a first mask applied from above to said first film to constitute the gate conductor lines of future transistors of the matrix;
deposition of a first insulating film (6) on the substrate (2) and the first conductive film;
deposition of a first hydrogenated amorphous silicon film (8) on the first insulating film (6);
deposition of a second $n^+$ type hydrogenated amorphous silicon film (10) on the first silicon film (8);
deposition of a positive photosensitive resin film (11) on the second silicon film (10);
irradiation of the resin film from below through the substrate, the gate conductor serving as an irradiation mask;
development of the resin film leading to the elimination of the irradiated zones of said resin film;
etching the first and second silicon films (8, 10) until the first insulating film (6) is exposed, the remaining resin (11) serving as a mask for said etching;
elimination of the remaining resin (11);
deposition of a second film of a second transparent conductive material (12) constituting the future source, drain and point electrode conductors;
second photogravure with the aid of a second mask, applied from above to the assembly constituted by the second conductive film (12) and the second silicon film (10) for defining the point electrodes, drain and source conductors of the matrix.

3. Process according to claim 2, characterized in that it comprises, following the second photogravure applied to the assembly constituted by the second conductive film (12) and the second silicon film (10) and the elimination of the remaining resin (13) the deposition of a second insulating film (14) on the second conductive film (12), the deposition of a film (16) of a third light-opaque material to the second insulating film (14) and the third photogravure with the aid of a third mask applied from above to the assembly constituted by the third opaque film (16) and the second insulating film (14) and the first silicon film (8) for defining a light shield (18) protecting each transistor.

4. Process according to any one of the claims 2 and 3, characterized in that the second conductive, transparent material (12) constituting the source and drain conductors and the pixels is tin and/or indium oxide.

5. Process according to any one of the claims 2 and 4, characterized in that the third light-opaque material (16) is a photosensitive polymer, which is coloured.

**Patentansprüche**

1. Matrix aus zusammengeschalteten Dünnfilmtransistoren insbesondere zur Steuerung der Anzeige auf flachen Flüssigkristallbildschirmen, bei denen der optische Transmissionszustand jedes Punkts des Schirms oder jedes Bildpunkts, der mit einem der Transistoren der Matrix verbunden ist, durch den elektrischen Zustand der Bildpunktelektrode (EP) des mit der Drainelektrode des entsprechenden Transistors verbundenen Bildpunkts gesteuert wird, welche auf einem Substrat die über Gateleiter (G), Sourceleiter (S) und Drainleiter (D), die entlang zweier senkrechter Richtungen der Matrix angeordnet sind, verbundenen Transistoren umfaßt, dadurch gekennzeichnet, daß:
- die Gateleiter (G) eine Leiterbahn, die auf dem Substrat angeordnet und in einer isolierenden Schicht (6) vergraben ist, die die gesamte Oberfläche dieses Substrats bedeckt, und eine Leitung aus einem ersten halbleitenden Material, die diese Gate-Leiterbahn überlagert, umfassen;

- die Sourceleiter (S) und die Drainleiter (D) ebenso wie die Bildpunktelektroden (EP) aus einem leitenden und transparenten Material gefertigt sind;
- die Matrix von einem Typ mit nicht gekreuzten Leitern ist, in dem Sinne, daß die Zeilen der Matrix jedes Mal von einem Gateleiter und einem daneben angeordneten Sourceleiter belegt sind, wobei die Transistoren durch Überlagerung unter einem rechten Winkel von einen von dem Gateleiter abgeleitete Arm (G1, G2, G3, G4), der sich entlang den Spalten der Matrix befindet, mit einem von dem Sourceleiter abgeleiteten Arm (S1, S2, S3, S4), der sich entlang der Spalten der Matrix zwischen den Sourceleitern und Gateleitern, die zu zwei benachbarten Leitungen der Matrix gehören, befindet, und dem Drainleiter (D1, D2, D3, D4) parallel zur Richtung der Zeilen der Matrix gebildet wird.

2. Verfahren zum Herstellen einer Matrix aus zusammengeschalteten Dünnfilmtransistoren insbesondere zur Steuerung der Anzeige auf flachen Flüssigkristallbildschirmen, bei denen der optische Transmissionszustand jedes Punkts des Schirms oder jedes Bildpunkts, der mit einem der Transistoren der Matrix verbunden ist, durch den elektrischen Zustand der Bildpunktelektrode (EP) des mit der Drainelektrode des entsprechenden Transistors verbundenen Bildpunkts gesteuert wird, welche auf einem Substrat die über Gateleiter (G), Sourceleiter (S) und Drainleiter (D), die entlang zweier senkrechter Richtungen der Matrix angeordnet sind, verbundenen Transistoren umfaßt, dadurch gekennzeichnet, daß es folgende Verfahrensschritte umfaßt:
    - Abscheiden einer ersten leitenden Schicht aus einem ersten metallischen, für das Licht undurchdringlichen Material (4) auf einem isolierenden Substrat,
    - erste Photoätzung mit Hilfe einer ersten Maske, die auf die erste Schicht angewandt wird, um entlang den Zeilen der Matrix die Leiterbahnen für Gates der zukünftigen Transistoren der Matrix zu bilden,
    - Abscheiden einer ersten isolierenden Schicht (6) auf dem Substrat (2) und der ersten leitenden Schicht,
    - Abscheiden einer ersten Schicht aus hydrogenisiertem, amorphen Silizium (8) auf der ersten isolierenden Schicht (6),

- Abscheiden einer zweiten Schicht aus hydrogenisiertem, amorphen Silizium des Typs $n^+$ (10) auf der ersten Siliziumschicht (8),
- Abscheiden einer Schicht aus positivem Photolack (11) auf der zweiten Siliziumschicht (10),
- Bestrahlen der Lackschicht von unten durch das Substrat, wobei der Gateleiter als Bestrahlungsmaske dient,
- Entwickeln der Lackschicht, was zum Entfernen der bestrahlten Bereiche der Lackschicht führt,
- Ätzen der ersten und zweiten Siliziumschichten (8) und (10) bis zum Freilegen der ersten Isolatorschicht (6), wobei der verbleibende Lack (11) als Maske für diese Ätzung dient,
- Entfernen des verbliebenen Lacks (11),
- Abscheiden einer zweiten Schicht aus einem zweiten transparenten, leitenden Material (12), das die künftigen Sourceleiter, Drainleiter und Bildpunktelektroden bildet, und anschließend einer neuen Lackschicht (13),
- zweites Photoätzen mit Hilfe einer zweiten Maske, das von oben auf die Anordnung von Photolack (13), zweiter Leiterschicht (12) - zweiter Siliziumschicht angewandt wird, um die Sourceleiter, Drainleiter ebenso wie die Bildpunktelektroden der Matrix abzugrenzen.

3. Verfahren nach Anspruch 2, dadurch gekennzeichnet, daß es nach den zweiten Photoätzen, das auf die Anordnung zweite Leiterschicht (12) - zweite Siliziumschicht (10) angewandt wird, und nach dem Entfernen des verbliebenen Lacks (13) folgende Schritte aufweist:
    - Abscheiden einer zweiten isolierenden Schicht (14) auf der zweiten leitenden Schicht (12),
    - Abscheiden einer Schicht aus einem dritten für das Licht undurchdringlichen Material (16) auf der zweiten Isolierschicht (14),
    - drittes Photoätzen mit Hilfe einer dritten Maske, das von oben auf die Anordnung von dritter, lichtundurchlässiger Schicht (16) - zweiter Isolatorschicht (14) und erster Siliziumschicht (8) angewandt wird, um einen Lichtschirm (18) abzugrenzen, der jeden Transistor schützt.

4.  Verfahren nach einen der Ansprüche 2 und 3, dadurch gekennzeichnet, daß das zweite leitende und transparente Material (12), das die Sourceleiter, Drainleiter und die Bildpunkte bildet, Zinn- und/oder Indiumoxyd ist.

5.  Verfahren nach einem der Ansprüche 2 bis 4, dadurch gekennzeichnet, daß das dritte, lichtundurchlässige Material (16) ein lichtempfindliches Polymer ist, welches man färbt.

FIG. 1

FIG. 2

FIG. 3

FIG. 4

FIG. 5

15

EP 0 256 053 B1

FIG. 6

FIG. 7

FIG. 8

FIG. 9

FIG. 10